# EUROPÄISCHE PATENTSCHRIFT

(11) **EP 1 163 322 B1**
(45) Veröffentlichungstag und Bekanntmachung des Hinweises auf die Patenterteilung: **01.12.2004**
(21) Anmeldenummer: 00907627.4
(22) Anmeldetag: 25.02.2000
(51) Int. Cl.: C11D 7/50, C23G 5/06, C11D 7/26, C11D 17/00

(54) **VERFAHREN ZUM FLÜSSIGREINIGEN VON GEGENSTÄNDEN**
METHOD FOR THE WET CLEANING OF OBJECTS
PROCEDE POUR NETTOYER DES OBJETS PAR VOIE HUMIDE

(30) Priorität: 26.02.1999 DE 19908434
(43) Veröffentlichungstag der Anmeldung: 19.12.2001
(73) Patentinhaber: Dr. O.K. WACK CHEMIE GmbH, D-85053 Ingolstadt (DE)
(72) Erfinder: WACK, Oskar, D-85053 Ingolstadt (DE)
(74) Vertreter: Kramer - Barske - Schmidtchen
(86) Internationale Anmeldenummer: PCT/EP2000/001565
(87) Internationale Veröffentlichungsnummer: WO 2000/050555

(56) Entgegenhaltungen:
- WO-A-92/20767
- WO-A-97/32963
- DE-A- 19 700 168
- US-A- 5 610 132
- PATENT ABSTRACTS OF JAPAN vol. 1998, no. 03, 27. Februar 1998 (1998-02-27) & JP 09 302391 A (OLYMPUS OPTICAL CO LTD), 25. November 1997 (1997-11-25)
- DATABASE WPI Section Ch, Week 199423 Derwent Publications Ltd., London, GB; Class D25, AN 1994-186549 XP002139155 & JP 06 122897 A (MITSUBISHI KASEI CORP), 6. Mai 1994 (1994-05-06)

## Beschreibung

Die Erfindung betrifft ein Verfahren und eine Verwendung von Reinigungsflüssigkeiten zum Flüssigreinigen von Gegenständen.

Bei der Flüssigreinigung werden entsprechend verschmutzte Gegenstände normalerweise mit in hoher Konzentration vorhandenem organischem Lösungsmittel in Berührung gebracht, das auf den jeweils zu entfernenden Schmutz abgestimmt ist. Eine Eigenart dieser Reinigungsverfahren besteht darin, dass verhältnismäßig viel Lösungsmittel gebraucht wird und wegen seiner Verunreinigung nachgeschärft werden muss. Des weiteren besteht, insbesondere wenn bei höherer als Zimmertemperatur gearbeitet wird, Feuergefahr, da die Lösungsmitteldämpfe meistens leicht entzündlich sind. Bei einer Reihe von Lösungsmitteln ist nicht auszuschließen, dass deren Rückstände auf der Oberfläche der gereinigten Gegenstände zurückbleiben, so dass der Reinigung eine oder mehrere Spülungen folgen müssen, um die Reingungsmittelrückstände zuverlässig zu entfernen.

Aus der WO 97/32963, von der im Oberbegriff der beigefügten unabhängigen Patentansprüche ausgegangen wird, ist ein Reinigungsverfahren beschrieben, bei dem eine azeotrope Zubereitung in Form einer Mischung aus Wasser und wenigstens einer weiteren Komponente mit Molekülen mit hydrophilen und lipophilen Gruppen verwendet wird, wobei die azeotrope Zubereitung dann besonders vorteilhafte Flüssigreinigungseigenschaften hat, wenn sie im Zustand einer Mischungslücke vorliegt.

Aus der WO 92/20767 ist ein Verfahren zur Anwendung inverser Dispersionen nicht mischbarer Lösungen für die Reinigung von Gegenständen bekannt. Bei diesem Verfahren, mit dem ein aktiver Bestandteil mittels eines Wasser-basierenden Trägers verteilt werden soll, werden organische Aerosol-Träger ersetzt, ohne daß auf einem mit einem Aerosol gereinigten Gegenstand wässrige Rückstände zurückbleiben.

Die US-A-5 610 132 beschreibt ein Reinigungsmittel, das aus einem gut wasserlöslichen Propylenglykolalkylether und einem wenig wasserlöslichem Propylenglykolalkylether und Wasser besteht, wobei maximal 55 Gew.-% Wasser vorhanden sind. Die Reinigungsflüssigkeit bildet eine einzige, homogene Phase, wobei jede Komponente in der anderen Komponente gelöst ist.

In der JP 09-302391 ist eine Reinigungsfüssigkeit beschrieben, die zu 0,1 bis 10 Gew.-% aus Wasser und einem nicht wässrigen Lösungsmittel besteht und oberhalb einer Temperatur zwischen 10 und 90°C einen Trübungspunkt hat, oberhalb dessen sie eine Emulsion vom Typ Wasser-in-Organik bildet.

Der Erfindung liegt die Aufgabe zugrunde, ein Verfahren und eine Verwendung einer Reinigungsflüssigkeit zum Flüssigreinigen von Gegenständen anzugeben, mit dem bzw. der eine effektive Flüssigreinigung verschmutzter Gegenstände möglich ist.

Der das Verfahren betreffende Teil der Erfindungsaufgabe wird mit den Merkmalen des Anspruchs 1 gelöst.

Überraschenderweise hat sich herausgestellt, dass bei Verwendung einer Reinigungsflüssigkeit aus Wasser und wenigstens einem Lösungsmittel, das mit Wasser eine Mischungslücke bildet und Arbeiten mit einer Lösungsmittelkonzentration, bei der die Reinigungsflüssigkeit im Zustand der Mischungslücke vorliegt, die gleiche oder sogar eine bessere Reinigungseffizienz erreicht wird, wie sie erreicht wird, wenn ausschließlich mit dem Lösungsmittel, d.h. dem Lösungsmittel in 100 %-iger Konzentration, gereinigt wird. Auf azeotrope Eigenschaften der Reinigungsflüssigkeit kommt es bei der Flüssigreinigung nicht an. Mit dem erfindungsgemäßen Verfahren kann die Konzentration des Lösungsmittels ganz erheblich herabgesetzt werden und liegt im allgemeinen lediglich im Bereich von 10 % - 20 %, so dass der Einsatz des Lösungsmittels erheblich vermindert ist. Auch bei erhöhter Temperatur hat der sich über der Reinigungsflüssigkeit bildende Dampf einen so hohen Wassergehalt, dass keine Entflammungsgefahr besteht. Ein zusätzlicher Vorteil des erfindungsgemäßen Verfahrens besteht darin, dass sich der zu entfernende Schmutz an der Oberfläche der wässrigen Phase der Reinigungsflüssigkeit absetzt und dort abgezogen werden kann, so dass die Reinigungsflüssigkeit bzw. das Lösungsmittel nur wenig nachgeschärft werden muss. Da die Reinigungsflüssigkeit auch bzw. vorwiegend Wasser enthält, wird bei der Flüssigreinigung nicht nur organischer Schmutz, sondern auch anorganischer Schmutz wirksam entfernt.

Typische Schmutzarten, für die das erfindungsgemäße Verfahren anwendbar ist, sind Öle, Fette. Flussmittel wie Harze, Pigmente, Staub. nicht ausgehärtete Epoxidmaterialien, wie z.B. Kleber. Rückstände von Läpp- und Polierpasten, Rückstände von Bearbeitungsflüssigkeiten wie Stanzöle, Bohr- und Schneidemulsionen usw. Besonders gut eignet sich das erfindungsgemäße Verfahren zur Reinigung von Leiterplatten, Schablonen, Metallteilen unterschiedlichster Geometrie und aus unterschiedlichsten Metallen. Typische organische Lösungsmittel sind Propylenglykolether, Ester, Ketone mit begrenzter Wasserlöslichkeit usw.

Das verwendete organische Lösungsmittel ist im Wasser innerhalb gewisser Mischungsverhältnisbereiche löslich ist, d.h. es bildet eine klare Lösung. In einem meist temperaturabhängigen Konzentrationsbereich ist eine Mischungslücke vorhanden, wobei sich die Reinigungsflüssigkeit im allgemeinen trübt bzw. eine Emulsion des Typs Lösungsmittel in Wasser bildet. Das Mischungsverhältnis der Reinigungsflüssigkeit wird bevorzugt so eingestellt, dass im bei der Flüssigreinigungstemperatur deutlich im Bereich der Mischungslücke gearbeitet wird, d.h.
dass nicht die Gefahr besteht, dass die Reinigungsflüssigkeit in den Zustand der echten Lösung übergeht.

Bei einer Mischung von Dipropylenglykol-n-propyl-ether beispielsweise beginnt die Mischungslücke, sobald bei etwa 20 °C mehr als 5 % des Lösungsmittels dem Wasser zugesetzt wird. Für ein gutes Reinigungsergebnis ist es vorteilhaft, mit mindestens 10 % Dipropylenglykol-n-propyl-ether in Wasser zu arbeiten.

Bevorzugt wird mit einer gewissen Mindestkonzentration an organischem Lösungsmittel gearbeitet, die bei 5, vorzugsweise 10 Gew.-% liegt.

Vorteilhaft ist, wenn während des Flüssigreinigens die Flüssigkeit in intensive Bewegung versetzt wird, beispielsweise mittels Ultraschalls. Dadurch werden einerseits die beiden Phasen der Reinigungsflüssigkeit gut durchmischt und andererseits eine massive mechanische Wechselwirkung zwischen der Reinigungsflüssigkeit und den zu reinigenden Gegenständen erzielt. Überraschenderweise reichen dabei verhältnismäßig geringe Anregungsleistungen des Ultraschallschwingers, wie sie für vorwiegend wässrige Reinigungsflüssigkeiten notwendig sind, um auch Schmutzarten wirksam zu entfernen, die herkömmlicherweise mit organischen Lösungsmitteln und hohen Ultraschallleistungen entfernt werden.

Die Reinigungstemperatur liegt bevorzugt in einem Bereich zwischen 20 und 50 °C. Damit können auch temperaturempfindliche Gegenstände problemlos gereinigt werden. Es wird nicht viel Heizenergie verbraucht. Die auftretenden Dampfdrucke sind gering, wodurch die Prozessführung einfach ist und die Umwelt gering belastet wird.

Der Anspruch 5 ist auf die Verwendung der Reinigungsflüssigkeit gerichtet. Diese Reinigungsflüssigkeit unterscheidet sich von herkömmlichen, wässrigen Reinigungsflüssigkeiten dadurch, dass sie, wie vorstehend erläutert, auch organische Verschmutzungen entfernt. Von herkömmlichen, auf organischen Lösungsmitteln basierenden Reinigungsflüssigkeiten unterscheidet sich die erfindungsgemäße dadurch, dass sie auch von typischen, mit Wasser entfernbaren Schmutzarten reinigt.

Vorteilhafterweise beträgt die Konzentration des organischen Lösungsmittels mindestens 5, bevorzugt mindestens 10 Gew.-%. Schon mit dieser Konzentration wird im allgemeinen eine Reinigungswirkung erzielt, die ähnlich gut oder sogar besser als die mit dem reinen Lösungsmittel erzielte ist, jedoch den Vorteil hat, dass auch wasserlöslicher Schmutz gelöst wird. Auf den weiteren Vorteil, dass sich beim Arbeiten mit einer trüben Lösung mit den vorgenannten Eigenschaften der gelöste Schmutz an der Oberfläche der wässrigen Phase der Flüssigkeit absetzt und dadurch leicht entfernt werden kann, sei nochmals hingewiesen.

Bei einer vorteilhaften Zusammensetzung ist das organische Lösungsmittel Propylenglykolether. der vorzugsweise in einer Konzentration zwischen 10 und 30 Gew.-%, bevorzugt 10 und 20 Gew.-% vorliegt. Eine solche Reinigungsflüssigkeit ist besonders vorteilhaft zum Reinigen von unterschiedlichsten Verschmutzungen, wie Ölen, Fette, Harze, Kleber usw. geeignet.

Bei einer anderen vorteilhaften Zusammensetzung ist das Lösungsmittel bzw. enthält es Etherazetat, beispielsweise Glykoletherazetat, in einer Konzentration beispielsweise zwischen 5 und 30 Gew.-%. vorzugsweise zwischen 5 und 15 Gew.-%. Eine solche Reinigungsflüssigkeit eignet sich besonders vorteilhaft zum Entfernen von nicht ausgehärteten Epoximaterialien und Klebern eignet. Als Propylenglykolether können beispielsweise Dipropylenglykol-n-propylether oder Dipropylenglykol-n-butylether verwendet werden.

Die Reinigungsflüssigkeit kann ein einfaches Zweiphasensystem aus Wasser und einem organischen Lösungsmittel sein. Geeignete Lösungsmittel sind beispielsweise Glykolether, Etherazetat, Butylazetat, Ester, wie Malonsäureester, Milchsäureester. Ketone, wie Azeton, Isobutylketon usw..

Es können mehrere organische Lösungsmittel vorhanden sein.

Die Reinigungsflüssigkeit kann ein gut wasserlöliches organisches Lösungsmittel enthalten, in dem ein schlecht wasserlösliches organisches Lösungsmittel gelöst ist, das auf diese Weise in das Wasser eingebracht ist.

Dazu wird beispielsweise eine Mischung aus 80 Gew.-% gut wasserlöslichem Lösungsmittel und 20 Gew.-% schlecht wasserlöslichem oder wasserunlöslichem Lösungsmittel bereitet und dann in einer Menge von 10 bis 20 Gew.-% in Wasser eingebracht.

Als gut wasserlösliches Lösungsmittel dient beispielsweise ein Glykolether, wie Propylenglykol-mono-methyl-ether. Dipropylenglykol-mono-methyl-ether oder Tripropylenolykol-mono-methyl-ether. Als schlecht wasserlösliches Lösungsmittel wird beispielsweise Propylenglykolether eingesetzt, wie Propylenglykol-mono-butyl-ether, Dipropylenglykol-mono-butyl-ether, Tripropylenglykol-mono-butyl-ether oder Propylenglykol-mono-methyl-ether-acetet, Propylenglykol-di-acetat, Dipropylenglykol-dimethyl-ether. Auch Terpene und höhere Alkohole können verwendet werden.

Zusammenfassend ermöglicht die Erfindung eine außerordentlich wirksame Reinigung von komplex verschmutzten Gegenständen mit geringem Lösungsmitteleinsatz, geringem Lösungsmittelverbrauch und geringer Umweltbelastung. Überraschenderweise werden mit geringeren Lösungsmittelkonzentrationen außerordentlich gute Reinigungswirkungen erzielt, beispielsweise können Kleber, insbesondere Epoxidkleber mit einer wässrigen Reinigungsflüssigkeit entfernt werden, die zu 90 % auf Wasser besteht.

Die für das erfindungsgemäße Verfahren verwendete Reinigungsflüssigkeit muß nicht zwingend eine trübe Emulsion sein. Die Emulsion kann auch transparent sein, wobei der Unterschied zwischen den beiden Emulsionen in deren Teilchengröße liegt. In milchig-trüben Emulsionen haben die in Wasser dispergierten Teilchen bzw. Tröpfchen des organischen Lösungsmittels allgemein einen Durchmesser von etwa 0,1 µm, während in transparenten Emulsionen die Teilchendurchmesser deutlich unter 0,1 µm liegen. Vorteilhaft sind jedoch größere Teilchendurchmesser, d.h. trübe Emulsionen.

Es versteht sich, dass der Reinigungsflüssigkeit weitere Bestandteile zugegeben werden können, beispielsweise Emulgatoren, Korrosionsinhibitoren usw. Bei den Reinigungsflüssigkeiten ist der Wassergehalt im allgemeinen erheblich größer als der Gehalt an organischem Lösungsmittel, so dass die innere, emulgierte Phase durch das Lösungsmittel gebildet ist und die äußere, zusammenhängende Phase durch das Wasser gebildet ist. Man spricht dann von einer Organik in Wasser oder Lösungsmittel in Wasser Emulsion. Zur Erkennung, ob es sich um eine solche Emulsion handelt, sei auf Römpps Chemielexikon, 8. Auflage. Franckh'sche Verlagshandlung, Stuttgart, 1981, Seite 1128 verwiesen.

## Patentansprüche

1. Verfahren zum Flüssigreinigen von Gegenständen, bei welchem Verfahren die zu reinigenden Gegenständen in intensive Berührung mit einer Reinigungsflüssigkeit gebracht werden, die Wasser und wenigstens ein organisches Lösungsmittel mit guten Lösungseigenschaften für zu entfernenden Schmutz enthält, wobei das Lösungsmittel derart gewählt ist, daß es unterhalb der bei der Flüssigreinigung vorhandenen Konzentration in Wasser löslich ist, die Reinigungsflüssigkeit bei der bei der Flüssigreinigung vorhandenen Konzentration und der bei der Flüssigreinigung herrschenden Temperatur jedoch im Zustand einer Mischungslücke vorliegt, wobei die innere, emulgierte Phase durch das (die) Lösungsmittel gebildet ist und die äußere, zusammenhängende Phase durch das Wasser gebildet ist,
**dadurch gekennzeichnet,**
**daß** die Reinigungsflüssigkeit keine azeotrope Zubereitung in Form einer Mischung aus Wasser und wenigstens einer weiteren Komponente mit hydrophilen und lipophilen Gruppen ist, wobei die weitere(n) Komponente(n) und das Wasser beim Phasenübergangflüssige Phase / Dampfphase .ein Azeotrop bilden.

2. Verfahren nach Anspruch 1, **dadurch gekennzeichnet**, das das organische Lösungsmittel in einer Konzentration von mindestens 5 Gew.-%, vorzugsweise mindestens 10 Gew.-% vorhanden ist.

3. Verfahren nach Anspruch 1 oder 2,**dadurch gekennzeichnet**, das unter Beaufschlagung mit Ultraschall gereinigt wird.

4. Verfahren nach einem der Ansprüche 1 bis 3, **dadurch gekennzeichnet, daß** die Temperatur, bei der flüssiggereinigt wird, zwischen 20° und 50° C liegt.

5. Verwendung einer Reinigungsflüssigkeit zum Flüssigreinigen von Gegenständen, wobei die zu reinigenden Gegenstände in intensive Berührung mit der Reinigungsflüssigkeit gebracht werden, die Wasser und wenigstens ein organisches Lösungsmittel mit guten Lösungseigenschaften für zu entfernenden Schmutz enthält, wobei das Lösungsmittel derart gewählt ist, daß es unterhalb der bei der Flüssigreinigung vorhandenen Konzentration in Wasser löslich ist, die Reinigungsflüssigkeit bei der bei der Flüssigreinigung vorhandenen Konzentration und der bei der Flüssigreinigung herrschenden Temperatur jedoch im Zustand einer Mischungslücke vorliegt, wobei die innere, emulgierte Phase durch das (die) Lösungsmittel gebildet ist und die äußere, zusammenhängende Phase durch das Wasser gebildet ist,
**dadurch gekennzeichnet,**
**daß** die Reinigungsflüssigkeit keine azeotrope Zubereitung in Form einer Mischung aus Wasser und wenigstens einer weiteren Komponente mit hydrophilen und lipophilen Gruppen ist, wobei die weitere(n) Komponente(n) und das Wasser beim Phasenübergangflüssige Phase / Dampfphase ein Azeotrop bilden.

6. Verwendung einer Reinigungsflüssigkeit nach Anspruch 5, welche Reinigungsflüssigkeit **dadurch gekennzeichnet ist, daß** das organische Lösungsmittel Propylenglykolether ist.

7. Verwendung einer Reinigungsflüssigkeit nach Anspruch 6, welche Reinigungsflüssigkeit **dadurch gekennzeichnet ist, daß** der Propylenglykolether in einer Konzentration zwischen 10 und 30 Gew.-%, vorzugsweise zwischen 10 und 20 Gew.-%, vorliegt.

8. Verwendung einer Reinigungsflüssigkeit nach Anspruch 5, welche Reinigungsflüssigkeit **dadurch gekennzeichnet ist, daß** das organische Lösungsmittel ein Etheracetat ist.

9. Verwendung einer Reinigungsflüssigkeit nach Anspruch 8, welche Reinigungsflüssigkeit **dadurch gekennzeichnet ist, daß** das Etheracetat in einer Konzentration zwischen 5 und 30 Gew.-%, vorzugsweise zwischen 5 und 15 Gew.-%, vorliegt.

10. Verwendung einer Reinigungsflüssigkeit nach einem der Ansprüche 5 bis 9, welche Reinigunghsflüssigkeit **dadurch gekennzeichnet ist, daß** die Reinigungsflüssigkeit aus Wasser und nur einem organischen Lösungsmittel besteht.

11. Verwendung einer Reinigungsflüssigkeit nach einem der Ansprüche in 5 bis 9, welche Reinigungsflüssigkeit **dadurch gekennzeichnet ist, daß** die Reinigungsflüssigkeit aus Wasser und wenigstens zwei organischen Lösungsmittel besteht, wobei ein erstes organisches Lösungsmittel gut wasserlöslich ist und ein zweites organisches Lösungsmittel schlecht wasserlöslich und gut im ersten organischen Lösungsmittel löslich ist.

## Claims

1. Method for the wet cleaning of objects, in which method the objects to be cleaned are brought into intensive contact with a cleaning liquid comprising water and at least one organic solvent with good solubility properties for the dirt to be removed, wherein said solvent is elected such that it is soluble in water at a concentration lower than the concentration being present at the wet cleaning, but the cleaning liquid at the concentration being present at the wet cleaning and at the temperature being present at the wet cleaning is in a state of a miscibility gap, wherein an inner emulsified phase is formed by said solvent and an outer coherent phase is formed by water, **characterized in that**
said cleaning liquid does not constitute an azeotropic composition in form of a mixture of water and at least one further component with hydrophilic and lipophilic groups, wherein the further component(s) form(s) an azeotrope at the phase transition liquid phase/vapor phase.

2. Method according to claim 1, **characterized in that** the organic solvent is present in a concentration of at least 5% by weight, preferably at least 10% by weight.

3. Method according to claim 1 or 2, that cleaning is undertaken under the effect of ultrasound.

4. Method according to one of the claims 1 through 3, **characterized in that** the temperature of the wet cleaning lies between 20° and 50° C.

5. Use of a cleaning liquid for the wet cleaning of objects, in which method the objects to be cleaned are brought into intensive contact with a cleaning liquid comprising water and at least one organic solvent with good solubility properties for the dirt to be removed, wherein said solvent is elected such that it is soluble in water at a concentration lower than the concentration being present at the wet cleaning, but the cleaning liquid at the concentration being present at the wet cleaning and at the temperature being present at the wet cleaning is in a state of a miscibility gap, wherein an inner emulsified phase is formed by said solvent and an outer coherent phase is formed by water, **characterized in that**
said cleaning liquid does not constitute an azeotropic composition in form of a mixture of water and at least one further component with hydrophilic and lipophilic groups, wherein the further component(s) form(s) an azeotrope at the phase transition liquid phase/vapor phase.

6. Use of a cleaning liquid according to claim 5, **characterized in that** the organic solvent is propylene-glycol-ether.

7. Use of a cleaning liquid according to claim 6, **characterized in that** the concentration of the propylene-glycol-ether lies between 10 and 30% by weight, preferably between 10 and 20% by weight.

8. Use of a cleaning liquid according to claim 5, **characterized in that** the organic solvent contains an ether-acetate.

9. Use of a cleaning fluid according to claim 8, **characterized in that** the ether-acetate has a concentration between 5 and 30% by weight, preferably between 5 and 15% by weight.

10. Use of a cleaning liquid according to one of the claims 5 through 9, **characterized in that** the cleaning fluid comprises water and only an organic solvent.

11. Use of a cleaning liquid according to one of the claims 5 through 9, **characterized in that** the cleaning fluid comprises water and at least two organic solvents, whereby a first organic solvent has good water-solubility and a second organic solvent has poor water solubility and can be dissolved well in the first organic solvent.

## Revendications

1. Procédé de nettoyage d'objets par voie humide, dans lequel les objets à nettoyer sont amenés en contact intense avec un liquide de nettoyage qui contient de l'eau et au moins un solvant organique avec de bonnes propriétés dissolvantes pour la saleté à enlever, le solvant étant choisi tel qu'il est soluble dans l'eau en dessous de la concentration présente lors du nettoyage par voie humide, le liquide de nettoyage étant toutefois à l'état d'une lacune de miscibilité sous la concentration présente lors du nettoyage par voie humide et à la température régnant lors du nettoyage par voie humide, la phase intérieure émulsionnée étant formée par le/les solvants, et la phase extérieure cohérente étant formée par l'eau,
**caractérisé en ce que** le liquide de nettoyage n'est pas une préparation azéotrope sous forme d'un mélange d'eau et d'au moins un autre composant à groupes hydrophiles et lipophiles, l'autre/les autres composant(s) et l'eau formant un azéotrope au point de transition phase liquide/phase vapeur.

2. Procédé selon la revendication 1, **caractérisé en ce que** le solvant organique est présent dans une concentration d'au moins 5 % en poids, de préférence au moins 10 % en poids.

3. Procédé selon l'une ou l'autre des revendications 1 et 2, **caractérisé en ce que** le nettoyage est effectué sous application d'ultrasons.

4. Procédé selon l'une des revendications 1 à 3, **caractérisé en ce que** la température à laquelle on procède au nettoyage par liquide est située entre 20° et 50°C.

5. Utilisation d'un liquide de nettoyage pour nettoyer des objets par voie humide, les objets à nettoyer étant amenés en contact intense avec le liquide de nettoyage qui contient de l'eau et au moins un solvant organique avec de bonnes propriétés dissolvantes pour la saleté à enlever, le solvant étant choisi tel qu'il est soluble dans l'eau en dessous de la concentration présente lors du nettoyage par voie humide, le liquide de nettoyage étant toutefois à l'état d'une lacune de miscibilité sous la concentration présente lors du nettoyage par voie humide et à la température régnant lors du nettoyage par voie humide, la phase intérieure émulsionnée étant formée par le/les solvants, et la phase extérieure cohérente étant formée par l'eau,
**caractérisée en ce que** le liquide de nettoyage n'est pas une préparation azéotrope sous forme d'un mélange d'eau et d'au moins un autre composant à groupes hydrophiles et lipophiles, l'autre/les autres composant(s) et l'eau formant un azéotrope au point de transition de phase liquide/phase vapeur.

6. Utilisation d'un liquide de nettoyage selon la revendication 5, le liquide de nettoyage étant **caractérisé en ce que** le solvant organique est de l'éther de propylène glycol.

7. Utilisation d'un liquide de nettoyage selon la revendication 6, le liquide de nettoyage étant **caractérisé en ce que** l'éther de propylène glycol est présent dans une concentration entre 10 et 30 % en poids, de préférence entre 10 et 20 % en poids.

8. Utilisation d'un liquide de nettoyage selon la revendication 5, le liquide de nettoyage étant **caractérisé en ce que** le solvant organique est de l'acétate d'éther.

9. Utilisation d'un liquide de nettoyage selon la revendication 8, le liquide de nettoyage étant **caractérisé en ce que** l'acétate d'éther est présent dans une concentration entre 5 et 30 % en poids, de préférence entre 5 et 15 % en poids.

10. Utilisation d'un liquide de nettoyage selon l'une des revendications 5 à 9, le liquide de nettoyage étant **caractérisé en ce qu'**il est constitué par de l'eau et par un seul solvant organique.

11. Utilisation d'un liquide de nettoyage selon l'une des revendications 5 à 9, le liquide de nettoyage étant **caractérisé en ce qu'**il est constitué par de l'eau et par au moins deux solvants organiques, un premier solvant organique étant bien soluble dans l'eau, et un deuxième solvant organique étant mal soluble dans l'eau et bien soluble dans le premier solvant organique.
